# EUROPÄISCHE PATENTSCHRIFT

(11) **EP 1 078 110 B1**
(45) Veröffentlichungstag und Bekanntmachung des Hinweises auf die Patenterteilung: **27.11.2002**
(21) Anmeldenummer: 99915435.4
(22) Anmeldetag: 27.04.1999
(51) Int. Cl.: C23C 14/06, C23C 14/02, C23C 28/00

(54) **WERKZEUG ODER MASCHINENBAUTEIL UND VERFAHREN ZU DESSEN HERSTELLUNG SOWIE VAKUUMBEHANDLUNGSANLAGE**
TOOL OR MACHINE COMPONENT AND METHOD FOR MAKING THE SAME AS WELL AS A VACUUMTREATMENTDEVICE
OUTIL OU ELEMENT DE MACHINE ET PROCEDE POUR LE PRODUIRE ET INSTALLATION DE TRAITMENT SOUS VIDE

(30) Priorität: 29.04.1998 CH 96698
(43) Veröffentlichungstag der Anmeldung: 28.02.2001
(73) Patentinhaber: Unaxis Trading AG, 9477 Trübbach (CH)
(72) Erfinder: DERFLINGER, Volker, A-6800 Feldkirch (AT); BRAENDLE, Hans, D-55424 Münster-Sarmsheim (DE); WOHLRAB, Christian, A-6800 Feldkirch (AT)
(74) Vertreter: Troesch Scheidegger Werner AG
(86) Internationale Anmeldenummer: CH9900172
(87) Internationale Veröffentlichungsnummer: WO99055929

(56) Entgegenhaltungen:
- EP-A- 0 394 661
- WO-A-97/34315
- DE-A- 2 136 532
- DE-A- 19 735 962
- US-A- 5 707 748

## Beschreibung

Die vorliegende Erfindung geht vom Bedürfnis aus, Werkzeuge, und dabei insbesondere Schneidwerkzeuge oder Umformwerkzeuge, mit einem Grundkörper aus Metall, dabei insbesondere aus HSS oder Werkzeugstahl oder aber aus einem Hartmetall, so zu beschichten, dass sie für den Trockenbearbeitungseinsatz bzw. für den Einsatz unter Minimalmengenschmierung (Mangelschmierung) etc. besonders gut geeignet sind.

Aus der erfindungsgemässen Lösung dieser Aufgabe ergibt sich eine Schutzbeschichtungstechnik, welche auch für weitere Werkzeuge und Maschinenbauteile besonders gut geeignet ist, wenn sie mit geringer oder keiner Schmierung eingesetzt werden und/oder unter hoher Flächenbelastung.

Unter ökologischen wie auch unter ökonomischen Gesichtspunkten ist der Betrieb sowohl von Werkzeugen, insbesondere von Schneidwerkzeugen und Umformwerkzeugen, unter Einsatz von Minimal-Schmiermittelmengen höchst interessant. Unter ökonomischen Aspekten ist zu berücksichtigen, dass die Kosten für kühlendes Schmiermittel insbesondere bei Schneidewerkzeugen um etliches höher liegen als für das Werkzeug selber. Mittels kühlender Schmiermittel am Werkzeug/Werkstück-Kontaktbereich werden Späne ausgespült sowie Wärme abgeführt, im weiteren wird ein reinigungs- und korrosionsvorbeugender Effekt erzielt.

Es besteht ein zunehmend ausgeprägtes Bedürfnis, vom Einsatz konventioneller Mengen kühlender Schmiermittel abzurücken, wie beispielsweise von 300 bis 4'000 l/h bei spanendem Werkzeugeinsatz, und die notwendigen Schmiermittelmengen drastisch, so z.B. auf lediglich 6 bis 70 ml/h, für gleiche Einsätze, zu reduzieren.

Dies stellt eine höchst anspruchsvolle Aufgabe, einerseits an die Formgebung der eingesetzten Werkzeuge, anderseits an die Oberflächenbhandlung solcher Werkzeuge und Maschinenbauteile. Die vorliegende Erfindung zielt auf das letzterwähnte Problem.

Im Kontext mit der erwähnten Problematik wird die obgenannte Aufgabe dadurch gelöst, dass ein Werkzeug oder Maschinenbauteil der im Oberbegriff von Anspruch 1 genannten Art vorgeschlagen wird, bei welchem, erfindungsgemäss und dem Kennzeichen von Anspruch 1 folgend, das Hartstoffschichtsystem mindestens eine Hartstoffschicht aus einem Material aus der Gruppe Nitride, Karbide, Oxide, Karbonitride, Oxinitride, Oxikarbonitride mindestens eines Metalles umfasst und unmittelbar zwischen der erwähnten, mindestens einen Hartstoffschicht und, in Richtung vom Grundkörperinnen gegen aussen fortschreitend vor dem Gleitschichtsystem, eine Zwischenschicht eingebaut ist aus demselben, mindestens einen Metall, welches auch die mindestens eine Hartstoffschicht des Hartstoffschichtsystems umfasst.

Aus der US 5 707 748 derselben Anmelderin wie vorliegende Anmeldung ist es bekannt, auf einem Werkzeuggrundkörper ein Hartstoffschichtsystem abzulegen, direkt gefolgt von einem Gleitschutzschichtsystem. Als Hartstoffschichtsystem-Materialien werden Metallkarbide, -nitride, -karbonitride oder Kombinationen davon vorgeschlagen, als Gleitschutzschichtsystem-Materialien Kohlenstoff-basierte Materialien, wie insbesondere Wolframkarbid mit dispersem Kohlenstoff, WC/C.

Dabei wird die bekannte Beschichtung vorgesehen, um die Standzeiten von Schneidwerkzeugen grundsätzlich zu erhöhen.

Die vorliegende Erfindung geht nun von der Erkenntnis aus, dass diese vorbekannte Beschichtungstechnik dann geeignet ist, den extremen, der zu lösenden Aufgabe zugrundeliegenden Anforderungen an Werkzeuge oder Maschinenbauteile, insbesondere auch an Schneidewerkzeuge, zu genügen, wenn das vorbekannte Gesamtschichtsystem wie erfindungsgemäss vorgeschlagen ausgebaut wird, insbesondere durch das erfindungsgemässe Vorsehen der metallischen Zwischenschicht.

Im weiteren wird die obgenannte Aufgabe durch ein Verfahren zur Herstellung eines Werkzeuges oder Maschinenbauteils mit erhöhter Verschleissfestigkeit nach dem Oberbegriff von Anspruch 19 gelöst, welches nach dessen Kennzeichnen durchgeführt wird.

Im weiteren wird eine Vakuumbehandlungsanlage insbesondere zur Ausführung des erfindungsgemässen Verfahrens vorgeschlagen gemäss dem Oberbegriff von Anspruch 27.

Aus der EP 0 394 661 ist eine derartige Anlage vorbekannt, mittels welcher Werkstücke mittels eines Sputter-CVD-Verfahrens wenigstens teilweise beschichtet werden, wobei Metalle der Gruppen IVb, Vb, VIb, VIII, Bor, Kohlenstoff, Silizium oder Legierungen mit einem wesentlichen Anteil dieser Elemente oder Verbindungen dieser Elemente untereinander oder mit den Metalloiden der Gruppen IVa, Va, VIa des Periodensystems abgeschieden werden. Eine Vakuumbehandlungskammer der Anlage weist in Öffnungen eine magnetfeldunterstützte Sputterquelle auf sowie eine Niedervoltbogenentladungsquelle. Als Anode dieser Niedervoltbogenentladungsquelle dient ein Verdampfungstiegel, und es ist zur Fokussierung und Führung des Niedervoltbogens ein Magnetfeld vorgesehen. Die Niedervoltbogenentladungsquelle hat weiter eine Wendel aus einer geeigneten refraktären Legierung, und es brennt die Niedervoltbogenentladung zwischen dieser Wendel und dem Verdampfungstiegel.

Ausgehend von einer derartigen Vakuumbehandlungsanlage wird gemäss dem Kennzeichen von Anspruch 27 vorgeschlagen, die erwähnte Niedervoltbogenentladungsquelle als Funkenverdampfungsquelle auszubilden und eine auch an der vorbekannten Anlage gemäss der EP 0 394 661 vorgesehene Transporteinrichtung mit Werkstückaufnahmen nun so auszubilden, dass mindestens ein Werkstück an den Öffnungen vorbeigeführt wird.

Das erfindungsgemässe Werkzeug oder Maschinenbauteil nach Anspruch 1 bzw. das erfindungsgemässe Verfahren nach Anspruch 19 mit ihren jeweils bevorzugten Ausführungsformen gemäss den Ansprüchen 2 bis 18 bzw. 20 bis 26 werden nachfolgend beispielsweise anhand von Figuren erläutert, ebenso wie erfindungsgemäss erzielte Resultate an Bohrern. Es zeigen:
- Fig. 1: rein qualitativ, ein erfindungsgemässes Schichtsystem auf einem Werkzeug- oder Maschinenbauteil-Grundkörper in Minimalkonfiguration,
- Fig. 2: entlang der Dickenausdehnung erfindungsgemäss realisierte, bevorzugte Konzentrationsverläufe, in schematischer, qualitativer Darstellung,
- Fig. 3: ausgehend von einer Darstellung gemäss Figur 1 eine weitere bevorzugte Ausführungsform des erfindungsgemässen Gesamtschichtsystems mit
- Fig. 4: in Darstellung analog zu Fig. 2, bevorzugten Konzentrationsverläufen,
- Fig. 5: ausgehend von den Darstellungen gemäss den Figuren 3 und 4, eine heute besonders bevorzugte Ausführungsvariante des erfindungsgemässen Gesamtschichtsystems,
- Fig. 6: schematisch, in Längsschnittdarstellung, eine erfindungsgemässe Anlage in vereinfachter Darstellung,
- Fig. 7: eine Gegenüberstellung von Bohrstandzeit-Resultaten mit erfindungsgemäss beschichteten Bohrern und Bohrern beschichtet nach dem Stande der Technik,
- Fig. 8: eine Gegenüberstellung des Verlaufes des Spindeldrehmomentes bei Bohren mittels herkömmlicher (a) und mittels erfindungsgemässer (b) Beschichtung.

### Grundkonfiguration

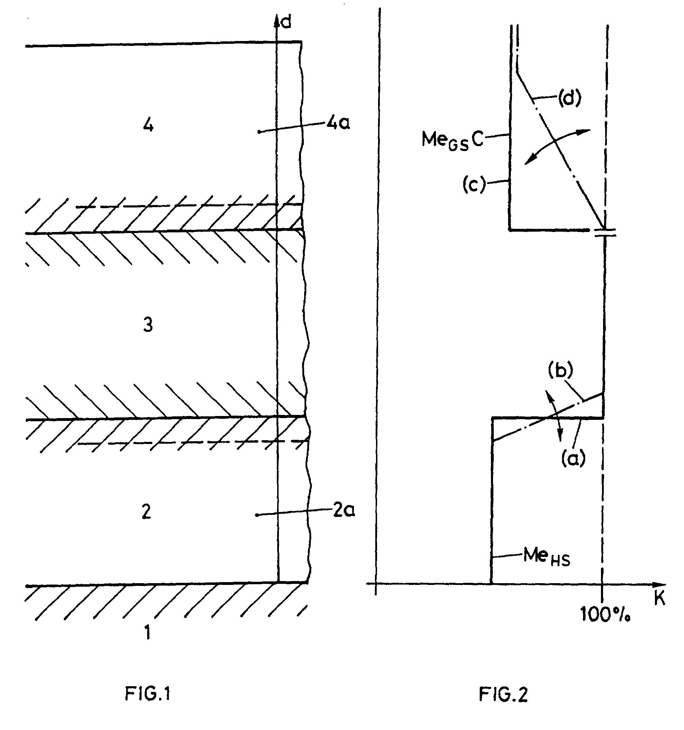

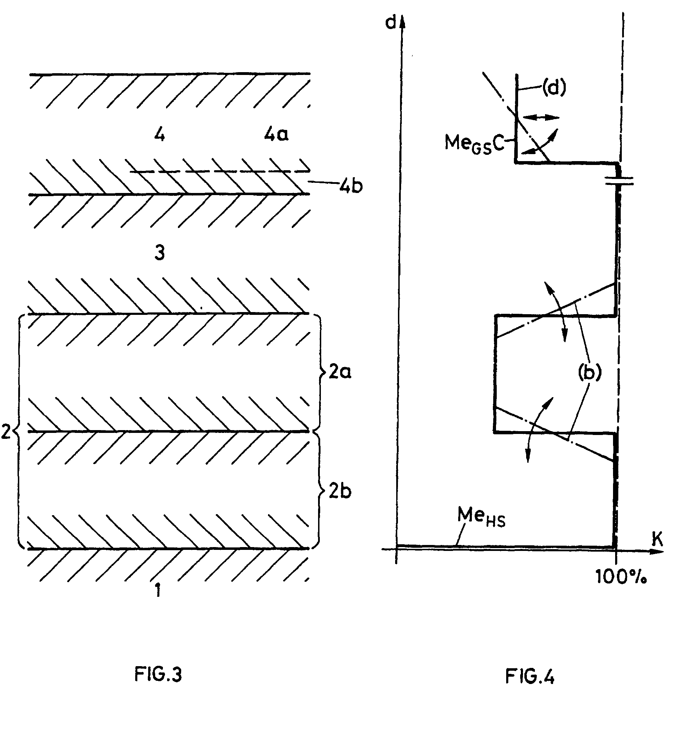

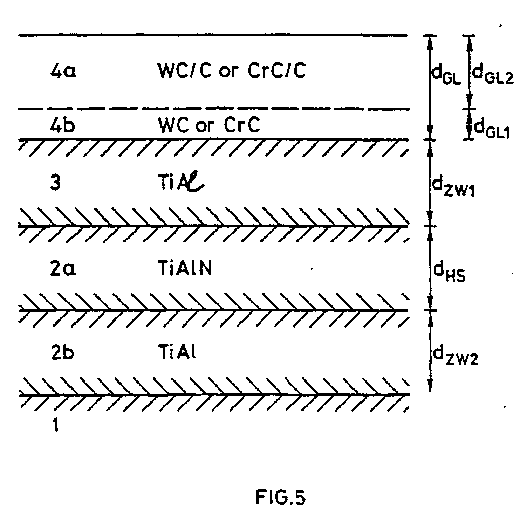

In Fig. 1 ist die Grund- oder Minimalkonfiguration des an einem erfindungsgemässen Werkzeug oder Maschinenbauteil vorgesehenen erfindungsgemässen Gesamtschichtsystems dargestellt. Dabei sei betont, dass die Darstellung bezüglich jeweiliger Dickendimensionierung nicht quantitativ zu verstehen ist, auch nicht bezüglich Dickenverhältnissen. Dies gilt auch für die Figuren 3 und 5.

Auf einem Grundkörper 1 aus einem Metall, dabei bevorzugt aus HSS oder einem Werkzeugstahl oder aber aus einem Hartmetall, ist ein Hartstoffschichtsystem 2 abgelegt, welches mindestens eine Hartstoffschicht 2a umfasst oder aus mindestens einer Hartstoffschicht 2a besteht, welch letztere aus einem Material der Gruppe Nitride, Karbide, Oxide, Karbonitride, Oxinitride, Oxikarbonitride mindestens eines Metalles gebildet ist.

Auf dem Hartstoffschichtsystem 2 ist eine metallische Zwischenschicht 3 abgelegt, welche aus demselben Metall besteht, wie das mindestens eine Metall in der erwähnten Hartstoffschicht 2a des Hartstoffschichtsystems 2. Dabei liegt bei mehrschichtigem Hartstoffschichtsystem 2 die erwähnte eine Hartstoffschicht 2a unmittelbar an der Zwischenschicht 3, wie dies gestrichelt in Fig. 1 dargestellt ist.

Über der Zwischenschicht 3 liegt ein Gleitschichtsystem 4. Dieses Gleitschichtsystem 4 umfasst wiederum mindestens eine Gleitschicht 4a oder wird durch eine Gleitschicht 4a gebildet, wobei im Falle eines mehrschichtigen Gleitschichtsystems, wie in Fig. 1 dargestellt, die eine nachfolgend betrachtete Gleitschicht 4a das Schichtsystem nach aussen abschliesst. Diese Gleitschicht 4a ist bevorzugt gebildet aus einem Karbid mindestens eines Metalles und dispersem Kohlenstoff, MeC/C.

Das für das Hartstoffschichtsystem 2 und insbesondere die erwähnte mindestens eine Schicht 2a eingesetzte Metall ist bevorzugt Titan, Hafnium, Zirkonium oder Aluminium, vorzugsweise zwei dieser Metalle, insbesondere bevorzugt TiAl. Das Gleitschichtsystem, und dabei insbesondere dessen mindestens eine Schicht 4a, ist bevorzugt aufgebaut aus einem Karbid mindestens eines Metalles der Gruppe IVb, Vb und/oder VIb und/oder von Silizium, dabei bevorzugt mit Wolframkarbid oder Chromkarbid, nebst dem mindestens in der erwähnten einen Gleitschicht 4a vorhandenden dispersen Kohlenstoff.

### Bevorzugte Schichtstruktur

In Fig. 3 ist, ausgehend von einer Darstellung gemäss Fig. 1, eine bevorzugte, von der Minimalkonfiguration von Fig. 1 ausgehende Schichtstruktur dargestellt. Es sind für bereits beschriebene Schichtstrukturteile dieselben Bezugszeichen verwendet. Auf dem Grundkörper 1 und im Hartstoffschichtsystem 2 ist eine weitere metallische Zwischenschicht 2b vorgesehen. Bevorzugterweise besteht auch sie, wie bereits die eine Zwischenschicht 3 gemäss Fig. 1, aus demselben Metall, wie in der mindestens einen Hartstoffschicht 2a des Hartstoffschichtsystems 2 enthalten.

Bevorzugterweise ist zwischen der erwähnten, mindestens einen Schicht 4a des Gleitschichtsystemes 4 und der Zwischenschicht 3, am Gleitschichtsystem 4 eine Schicht 4b vorgesehen, welche im wesentlich ausschliesslich aus dem Metallkarbid besteht. Disperser Kohlenstoff liegt in massgeblichem Umfange erst in der Schicht 4a vor. Das Gleitschichtsystem 4 weist bevorzugterweise eine etwas geringere Schichtdicke auf als das Hartstoffschichtsystem 2.

### Schichtübergänge

Betrachtet an der Minimalkonfiguration gemäss Fig. 1, und wie schematisch in Fig. 2 dargestellt, kann die Konzentration K des oder der in der Hartstoffschicht 2 insbesondere in der mindestens einen Hartstoffschicht 2a vorgesehenen Metalles Me_{HS} durch das Hartstoffsystem und insbesondere durch die mindestens eine Schicht 2a konstant verlaufen, um dann zur Metallschicht 3 sprunghaft auf mindestens genähert 100 % anzusteigen (a). Es kann aber, durch Führung des Beschichtungsprozesses, und wie mit (b) dargestellt, ein abgestufter, bevorzugterweise im wesentlicher stetiger Übergang der Konzentration Me_{HS} vom Hartstoffsystem 2 zur Metallzwischenschicht 3 realisiert.

Im Gleitschichtsystem 4 kann die Metallkarbidkonzentration Me_{GS}C, wie bei (c) dargestellt, insbesondere in der mindestens einen vorgesehenen Gleitschicht 4a konstant verlaufen, oder die Konzentration bzw. der Gehalt an Metallkarbid kann bevorzugterweise gegen aussen, wie bei (d) schematisch dargestellt, in Schritten oder stetig abnehmen.

Bei der bevorzugten Ausführungsform gemäss Fig. 3, und wie in Analogie zu Fig. 2, in Fig. 4 dargestellt, kann der Gehalt des Metalles Me_{HS} in der weiteren Metallzwischenschicht 2b beim Übergang zum weiteren Hartstoffschichtsystem 2a im wesentlichen abrupt abfallen, um dann beim Übergang zur Metallzwischenschicht 3 wieder abrupt auf mindestens genähert 100 % anzusteigen. Anderseits kann, wie bei (b) von Fig. 4 dargestellt, am einen und/oder andern der erwähnten Übergänge eine abgestufte, vorzugsweise stetige Konzentrationsänderung von Me_{HS} realisiert werden.

Im Gleitschichtsystem 4 liegt bevorzugt in der Schicht 4b eine praktisch 100%ige Me_{GS}C-Konzentration vor, welche aufgrund des hinzukommenden dispersen Kohlenstoffes, wie bei (d) von Fig. 4 dargestellt, abrupt oder abgestuft, dabei bevorzugt stetig gegen aussen abnimmt.

### Heute bevorzugter Schichtaufbau

In Fig. 5 ist der heute bevorzugte Gesamtschichtaufbau in Darstellung analog zu den Fig. 1 und 3 dargestellt.

Falls vorgesehen, besteht die Zwischenschicht 2b gemäss Fig. 3 aus TiAl. Das weitere Hartstoffschichtsystem 2a oder, ohne Zwischenschicht 2b, das Hartstoffschichtsystem 2 an sich, besteht im wesentlich aus TiAlN.

Die Zwischenschicht 3 besteht im wesentlichen wiederum aus Ti-Al.

Falls vorgesehen, besteht 4b gemäss Fig. 3 im wesentlichen aus Wolframkarbid oder Chromkarbid, das Gleitschichtsystem 4a aus Wolframkarbid oder Chromkarbid und dispersem Kohlenstoff C.

### Bevorzugte Dickendimensionierungen

### • Hartstoffschichtsysteme:

Das Hartstoffschichtsystem 2, insbesondere in seiner bevorzugten Ausführungsform gemäss Fig. 5 aus TiAlN, weist eine Dicke d_{HS} auf wie folgt:
0,1 µm ≤ d_{HS} ≤ 6 µm,
dabei bevorzugt
2 µm ≤ d_{HS} ≤ 5 µm.

### • Metallzwischenschicht 3:

Die Metallzwischenschicht 3, insbesondere, wenn aus TiAl gemäss Fig. 5 bestehend, weist eine Dicke d_{ZW1} auf:
0,01 µm ≤ d_{ZW1} ≤ 1 µm,
bevorzugt
0,1 µm ≤ d_{ZW1} ≤ 0,5 µm.

### • Gleitschichtsystem 4:

Das Gleitschichtsystem 4 weist insbesondere in bevorzugter Ausführungsform gemäss Fig. 5 eine Dicke d_{GL} auf wie folgt:
0,1 µm ≤ d_{GL} ≤ 6 µm,
dabei bevorzugt
2 µm ≤ d_{GL} ≤ 3,5 µm.

Ist gemäss Fig. 3 bzw. 5 das Gleitschichtsystem in die im wesentlichen reine Karbidschicht 4b und das restliche Schichtsystem 4a mit dispersem Kohlenstoff unterteilt, so werden die zugeordneten Dicken d_{GL1} und d_{GL2} bevorzugt wie folgt gewählt:
0,01 µm ≤ d_{GL1} ≤ 1 µm,
bevorzugt
0,1 µm ≤ d_{GL1} ≤ 0,5 µm
bzw.
0,1 µm ≤ d_{GL2} ≤ 5 µm,
bevorzugt
2 µm ≤ d_{GL2} ≤ 3 µm.

### • Zwischenschicht 2b:

Falls vorgesehen, wird die weitere Metallzwischenschicht 2b mit einer Dicke d_{ZW2} wie folgt dimensioniert:
0,01 µm ≤ d_{ZW2} ≤ 1 µm,
dabei bevorzugt
0,1 µm ≤ d_{ZW2} ≤ 0,5 µm.

### Beschichtungsverfahren

### • Hartstoffsystem

Das Hartstoffschichtsystem mit der wie erwähnt mindestens einen Hartstoffschicht, bevorzugt aus TiAlN, kann durch reaktives Sputtern, dabei bevorzugt reaktives Magnetronsputtern oder durch reaktives kathodisches Funkenverdampfen abgelegt werden. Bevorzugt wird es durch reaktives kathodisches Funkenverdampfen abgelegt. Dadurch entstehen dichte ionenplattierte Strukturen, porenfrei und mit gleichmässigen Übergängen zu den anschliessenden Schichtsystemen bzw. zum Grundkörpermaterial.

### • Zwischenschicht 3

Die Zwischenschicht 3, aus demselben Metall, wie im Hartstoffsystem 2 mit der mindestens einen Schicht 2a enthalten, gemäss Fig. 5 vorzugsweise aus TiAl, wird bevorzugterweise dadurch abgelegt, dass dasselbe Beschichtungsverfahren, wie für das Hartstoffschichtsystem 2 eingesetzt, nichtreaktiv weitergeführt wird. Ein gestufter, vorzugsweise stetiger Übergang zwischen Hartstoffschichtsystem und Zwischenschicht 3, wie in Fig. 2 bei (b) schematisiert, erfolgt durch gezielt gesteuerte Reduktion des Reaktivgasflusses, bei der Ausführungsvariante gemäss Fig. 5 des Flusses stickstoffenthaltenden Gases, bis hin zum nichtreaktiven Metallsputtern, jedoch bevorzugt zum nichtreaktiven metallischen Funkenverdampfen.

### • Gleitschichtsystem 4

Das Gleitschichtsystem wird durch kathodisches Funkenverdampfen oder, bevorzugt, durch Sputtern eines Targets, insbesondere Magnetronsputtern eines Targets, realisiert, unmittelbar oder, für die Ausführungsform gemäss Fig. 5 zeitgestaffelt, in einer Kohlenstoff-enthaltenden Atmosphäre, wie in einer Atmosphäre mit C₂H₂, C₂H₄ etc. Bevorzugt werden Karbidtargets verwendet.

Gegenüber dem ebenfalls möglichen reaktiv Sputtern metallischer Targets hat das Sputtern von Karbidtargets den Vorteil, einen insgesamt höheren C-Gehalt in der abgelegten Schicht zu bewirken. Es entsteht eine Matrix amorphen Kohlenstoffes mit nanokristallinen Karbidkörnern. Dadurch dass die Werkstücke zyklisch mehr und weniger der mindestens einen Karbidquelle, insbesondere der mindestens einen Karbidsputterquelle, ausgesetzt werden, entsteht, höchst vorteilhaft für ein Gleitschichtsystem, eine Laminar-Mikrostruktur von Lagen mit wechselndem Anteil dispersen Kohlenstoffes zu Karbidanteilen. Abgestufte Übergänge, wie in den Fig. 2 und 4 jeweils bei (d) schematisiert, werden durch gezielte Steuerung des Kohlenstoffanteiles in der Sputteratmosphäre im Verhältnis zur gesputterten Materialmenge realisiert.

### • Vorbehandlung der Grundkörper-Oberfläche

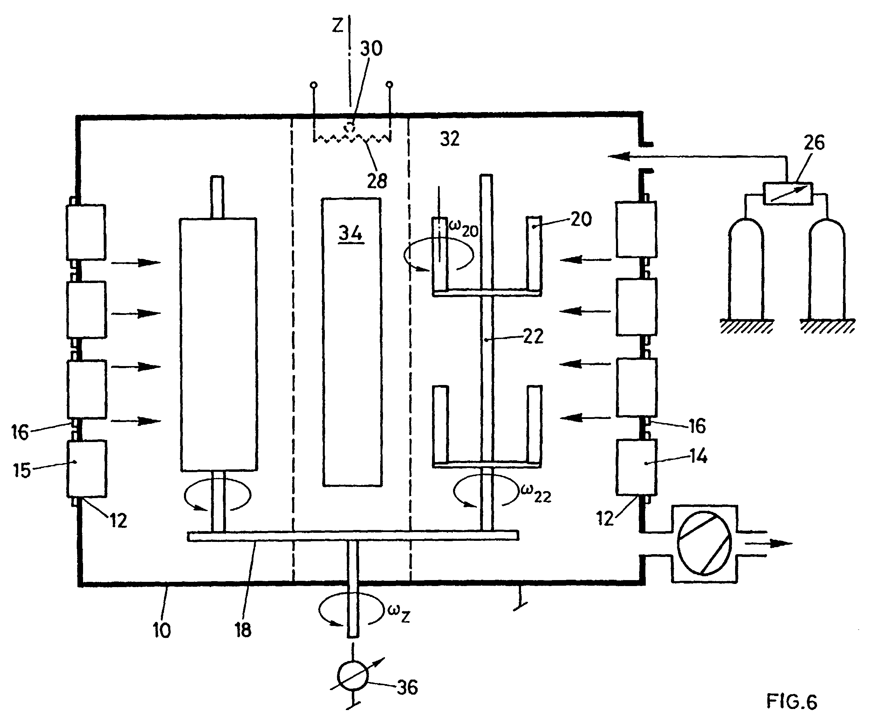

Es wird angeraten, die Grundkörper-Oberfläche vor der Beschichtung plasmazuätzen, insbesondere mittels einer Niederspannungsentladung. In der nachfolgenden Tabelle sind die verwendeten Grössen der massgeblichen Prozessparameter für die erfindungsgemässe Beschichtung gemäss Fig. 5 und mit einer Anlage gemäss Fig. 6 zusammengestellt.

| | TiAl | TiAlN | TiAl | WC | WC/C |
|---|---|---|---|---|---|
| P_{TiAl}[kW] | 6 | 6 | 6 | - | - |
| P_{WC}[kW] | - | - | - | 4 | 4 |
| p_{N2}[mbar] | - | 0.5 - 5x10⁻² | - | - | - |
| p_{Ar}[mbar] | 0.5 - 5x10⁻² | - | 0.5 - 5x10⁻² | 0.5 - 5x10⁻² | 0.5 - 5x10⁻² |
| p_{C2H2}[mbar] | - | - | - | - | 0 - 3x10⁻² |
| U_{subtr.}[-V] | 20 - 200 | 20 - 200 | 20 - 200 | 1 - 200 | 0 - 10(*) |

| | | | | | |
|---|---|---|---|---|---|
| Temperaturbereich: T = 200 - 500°C (*) auch positiv möglich | | | | | |

### Anlagenkonfiguration

In Fig. 6 ist schematisch eine erfindungsgemässe Anlage zur Ausführung des erfindungsgemässen Verfahrens vereinfacht dargestellt. Sie entspricht weitestgehend der in der WO97/34315 derselben Anmelderin beschriebenen Anlagenkonzeption, die zum integrierten Bestandteil vorliegender Beschreibung erklärt wird. Sie umfasst einen Vakuumrezipienten 10 mit einer Mehrzahl entlang ihrer Wandung vorgesehener, vorzugsweise runder Öffnungen 12. Weiter ist ein Satz mehrerer Funkenverdampfungsquellen 14 und Sputterquellen 15, vorzugsweise Magnetronquellen, vorgesehen. Alle vorgesehenen Quellen des Satzes und die Öffnungen 12 am Vakuumrezipienten 10 sind bezüglich dem Anbringen dieser Quellen an die Öffnungen 12 identisch ausgebildet, so dass frei gewählt werden kann, welche Quellen an welche Öffnungen des Rezipienten angebracht werden sollen. Bevorzugterweise sind Schnellverschlüsse, wie bei 16 schematisch dargestellt, vorgesehen, beispielsweise Bajonettverschlüsse, womit, gleichgültig welche, Sputter- oder Funkenverdampferquellen beliebig frei am Rezipienten rasch aufgesetzt werden können. In der bevorzugten Konfiguration gemäss Fig. 6 liegen sich mindestens eine Reihe von Sputterquellen 15 und mindestens eine Reihe von Funkenverdampferquellen 14 gegenüber. Im Rezipienten 10 ist eine Werkstückträgeranordnung 18 vorgesehen, womit, wie schematisch dargestellt, Werkstücke 20 um die Zentralachse Z des Rezipienten - ω_{z} - und somit an den unterschiedlichen Quellen 14, 15 vorbeibewegt werden. Die Werkstücke 20 sind an Aufnahmebäumen 22 positioniert, welche ihrerseits bevorzugterweise, und wie mit ω₂₂ dargestellt, in Drehbewegung versetzt werden, während die Werkstücke 20 selbst ggf., und wie mit ω₂₀ dargestellt, um ihre jeweilige Achse in Rotation versetzt werden. In den Rezipienten 10 werden, gesteuert durch eine Gasflusssteuereinheit 26, die benötigten Gase, wie insbesondere Stickstoff-enthaltendes Gas und Kohlenstoff-enthaltendes Gas, je nach Prozessphase gesteuert eingelassen. Gestrichelt ist bei 28 die Heisskathode einer Niederspannungsentladungsstrecke dargestellt, mit Gaseinlass 30, bevorzugterweise für Argon. Die Niederspannungsentladungskammer 32 steht mit dem Behandlungsrezipienten über die schematisch dargestellte Schlitzöffnung 34 in Verbindung. Mit dieser Niederspannungsentladungsanordnung werden die Werkstücke 20, vor Beschichtung, durch die Öffnung 34 geätzt. Die Werkstücke 20 werden, wie schematisch bei 36 dargestellt, mittels einer elektrischen Generatoreinheit auf das jeweils geforderte elektrische Potential gelegt.

Es ist ersichtlich, dass gemäss dem bevorzugten Verfahren für das Ablegen des Hartstoffschichtsystems erst ausschliesslich die Funkenverdampferquellen 14 reaktiv, bevorzugt unter Einlass stickstoffhaltigen Reaktivgases, betrieben werden, für das Ablegen der metallischen Zwischenschichten der Reaktivgasfluss mit der Einheit 26 abrupt gestuft oder stetig zurückgefahren wird, und dass für das Ablegen des Gleitschichtsystems die Sputterquellen 15 bevorzugt mit karbidischen Targets in Betrieb gesetzt werden, unter Einlass von kohlenstoffhaltigem Gas, gesteuert mit der Einheit 26. Die Schichtübergänge werden nach Wunsch durch entsprechende Veränderung der Gasflüsse und/oder der Verdampfer- bzw. Sputterleistungen realisiert. Beim Ablegen des Gleitschichtsystemes, bei welchem die Funkenverdampfungsquellen 14 stillgesetzt sind, ergeben sich, wie bereits erwähnt wurde, zyklisch Phasen, während welchen die Werkstücke 20 vermehrt den Sputterquellen 15 ausgesetzt sind (linke Position der Werkstücke) und dann von diesen Quellen wieder mehr beabstandet sind, dabei weiterhin dem Einfluss des Kohlenstoffgases ausgesetzt sind. Dadurch ergibt sich die erwähnte bevorzugte Laminarstruktur am Gleitschichtsystem.

### Resultate

Insbesondere durch die kombinierte Beschichtung durch Sputtern und Funkenverdampfen ergibt sich bei Realisation der erfindungsgemässen Schichtstruktur eine dichte, harte Beschichtung mit ausgezeichnetem Gleit- und Haftverhalten.

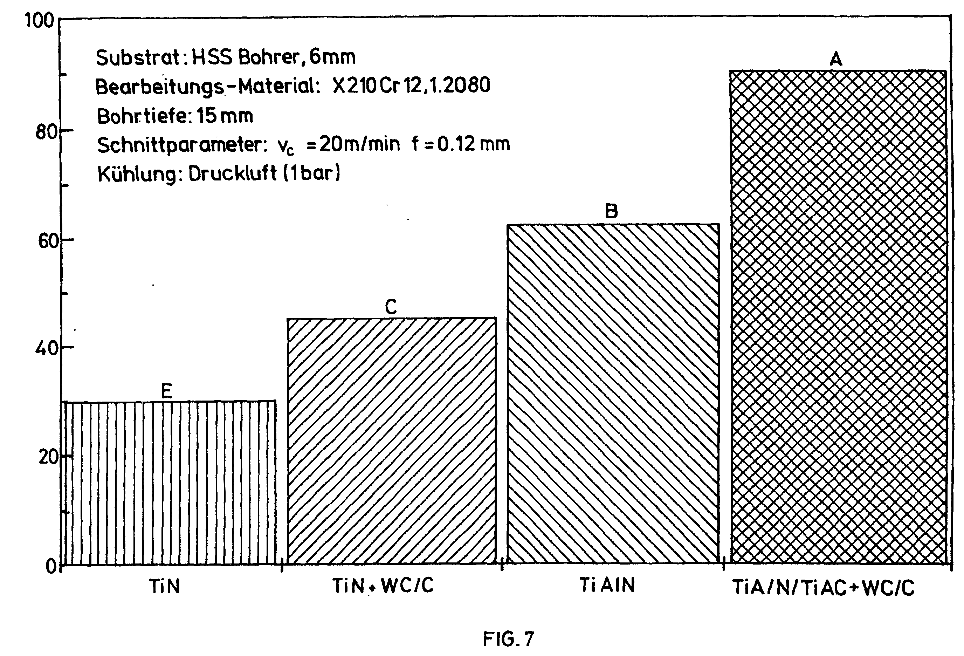

In Fig. 7 sind Bohrresultate dargestellt. 6 mm-HSS-Bohrer wurden getestet an X210Cr12-Material mit einer jeweiligen Bohrtiefe von 15 mm. Bohrparameter waren:
Vorschub v_{c} = 20 m/min
f = 0,12 mm.

Es wurde lediglich Druckluft bei 1 bar eingesetzt. Es muss betont werden, dass die eingesetzten Bohrer nicht für eine Trokkenbearbeitung, wie vorgenommen, geformt waren, sondern, dass es ausschliesslich darum ging, das Verhalten der verschiedenen Beschichtungssysteme zu vergleichen. Auf der Vertikalachse von Fig. 7 ist die jeweils mit den Bohrern erreichte Gesamtlochzahl, die der Standzeit entspricht, aufgetragen.

Es ist ersichtlich, dass mit den erfindungsgemäss beschichteten Bohrern gemäss Balken A wesentlich bessere Resultate erzielt wurden als mit Bohrern gemäss Balken B, die lediglich mit einer TiAlN-Hartstoffbeschichtung versehen sind oder als mit Bohrern mit einer Hartstoffbeschichtung aus TiN und anschliessender Gleitschichtbeschichtung mit Wolframkarbid und dispersem Kohlenstoff - Balken C - oder entsprechend Balken E, als mit Bohrern mit der Hartstoffbeschichtung TiN. Die Beschichtung an den Bohrern gemäss Balken C entspricht im wesentlichen einer Beschichtung gemäss der US-A-5 707 748.

Daraus ist klar ersichtlich, dass die erfindungsgemäss beschichteten Werkzeuge bzw. Bohrer ausgezeichnete Trockenbearbeitungseigenschaften bezüglich Standzeiten aufweisen.

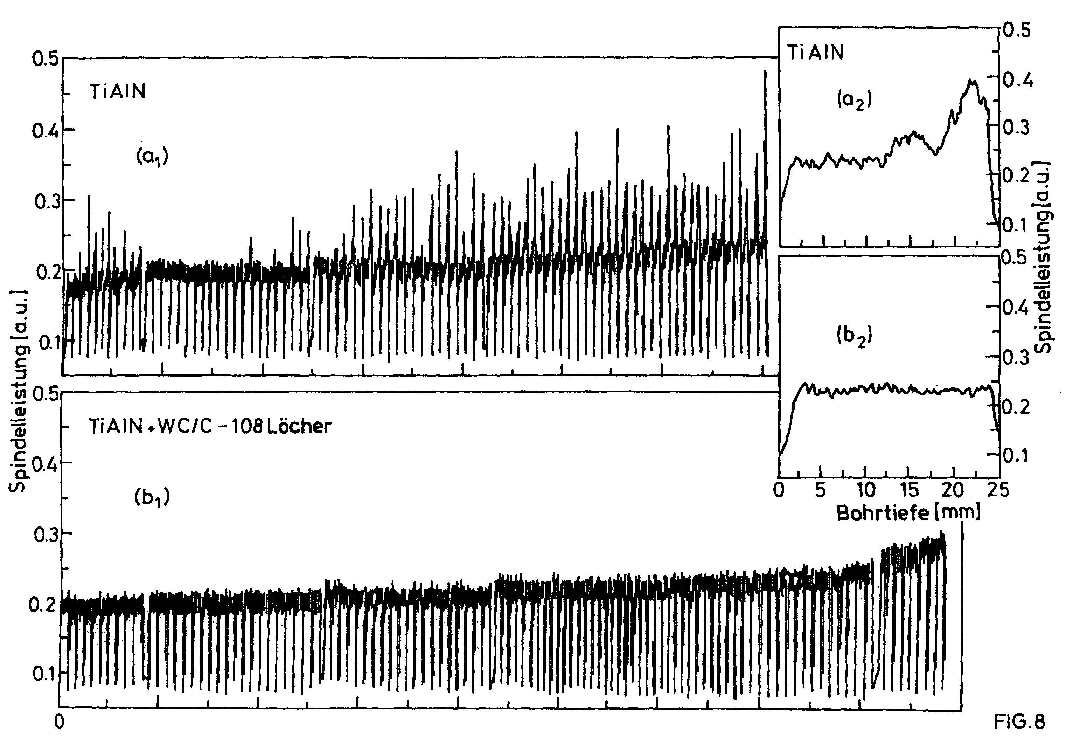

In Fig. 8 sind in Darstellung (a₁) und zugehörige Darstellung (a₂), in Relativgrössen, die Verläufe des Antriebsdrehmomentes der Bohrspindel aufgetragen, gemäss (a₁) für eine Vielzahl sich folgender Bohrungen, gemäss (a₂) bei Betrachtung einer einzelnen Bohrung. Die Verläufe (a) wurden an Bohrern gemessen mit einer TiAlN-Hartstoffbeschichtung. Die analog dargestellten Verläufe (b₁) und (b₂) wurden an erfindungsgemäss beschichteten Bohrern aufgenommen.

Es ist ohne weiteres ersichtlich, vorerst bei Vergleich der Verläufe (a₂) und (b₂), dass ab einer gewissen Bohrtiefe das notwendige Drehmoment zur Aufrechterhaltung konstanter Drehzahlen, gemäss (a₂) an Bohrern mit vorbekannter Hartstoffbeschichtung, wesentlich zunimmt, was zu den Drehmomentspitzen gemäss (a₁) führt, während an den erfindungsgemäss beschichteten Bohrern, wie insbesondere aus (b₂) ersichtlich, auch bei relativ grosser Bohrtiefe, keinerlei Zunahme des notwendigen Antriebsdrehmomentes zu beobachten ist. Dies zeigt die ausgezeichneten Gleiteigenschaften der erfindungsgemäss beschichteten Bohrer, was in Kombination mit den Resultaten gemäss Fig. 7, nämlich der Bohrerstandzeit, klar belegt, dass die erfindungsgemäss beschichteten Bohrer aufgrund ihrer ausgezeichneten Gleiteigenschaften und gleichzeitig der ausgezeichneten Standzeiten sich besonders gut für den Einsatz unter Trockenbearbeitungsbedingungen bzw. Mangelschmierungsbedinungen eignen. Druckluft wurde eingesetzt, um eine Beeinträchtigung der Bohrer durch gehärtete, deformierte Späne zu verhüten. Im weiteren muss darauf hingewiesen werden, dass beide Diagramme nach (a₂) und (b₂) nach dem jeweiligen Bohren von 80 Löchern aufgenommen sind.

Damit wird durch die vorliegende Erfindung ein Beschichtungssystem vorgeschlagen, welches nebst ausgezeichneten Verschleisseigenschaften ausgezeichnete Gleiteigenschaften und ausgezeichnete Hafteigenschaften aufweist. Es eignet sich, wie erwähnt wurde, insbesondere für Werkzeuge und Maschinenbauteile, bei Werkzeugen insbesondere für Schneidwerkzeuge und Umformungswerkzeuge, die unter Minimalschmierbedingungen oder gar im Trockenlauf betrieben werden.

## Patentansprüche

1. Werkzeug oder Maschinenbauteil, umfassend:
- einen Grundkörper (1) aus einem Metall oder aus Hartmetall;
- vom Grundkörperinnern gegen aussen fortschreitend (d), erst einem Hartstoffschichtsystem (2), mindestens über einem Teil der Grundkörper-Oberfläche, gefolgt von einem Gleitschichtsystem (4);
**dadurch gekennzeichnet, dass**
- das Hartstoffschichtsystem (2) mindestens eine Hartstoffschicht (2a) aus einem Material aus der Gruppe Nitride, Karbide, Oxide, Karbonitride, Oxinitride, Oxikarbonitride mindestens eines Metalles umfasst;
- unmittelbar zwischen der erwähnten, mindestens einen Hartstoffschicht (2a) und, in der erwähnten Richtung (d) fortschreitend, vor dem Gleitschichtsystem (4) eine Zwischenschicht (3) vorhanden ist aus demselben, mindestens einen Metall, welches die mindestens eine Hartstoffschicht (2a) des Hartstoffschichtsystems (2) umfasst.

2. Werkzeug oder Maschinenbauteil nach Anspruch 1, **dadurch gekennzeichnet, dass** das Gleitschichtsystem (4) mindestens eine Gleitschicht (4a) umfasst, die aus einem Karbid mindestens eines Metalles mit dispersem Kohlenstoff, MeC/C, besteht.

3. Werkzeug oder Maschinenbauteil nach einem der Ansprüche 1 oder 2, **dadurch gekennzeichnet, dass** die mindestens eine Hartstoffschicht (2a) mindestens eines der Metalle Titan, Hafnium, Zirkonium, Aluminium umfasst, vorzugsweise mindestens zwei dieser Metalle, dabei bevorzugt TiAl, wobei weiter bevorzugterweise die erwähnte Hartstoffschicht aus TiAlN besteht.

4. Werkzeug oder Maschinenbauteil nach einem der Ansprüche 1 bis 3, **dadurch gekennzeichnet, dass** mindestens eine Schicht (4a) des Gleitschichtsystems ein Karbid mindestens eines Metalles der Gruppe IVb, Vb, VIb des Periodensystems der Elemente (Deming 1923) oder von Silizium umfasst, dabei bevorzugt Wolframkarbid oder Chromkarbid, dabei vorzugsweise eine Schicht, welche unmittelbar an der einen Zwischenschicht anliegt.

5. Werkzeug oder Maschinenbauteil nach einem der Ansprüche 1 bis 4, **dadurch gekennzeichnet, dass** zwischen Grundkörperoberfläche (1) und der mindestens einen Schicht (2a) des Hartstoffschichtsystems (2) eine weitere Zwischenschicht (2b), vorzugsweise aus einem Metall, vorhanden ist, dabei bevorzugt aus demselben, mindestens einen Metall, welches auch die mindestens eine Schicht (2a) des Hartstoffschichtsystems (2) umfasst.

6. Werkzeug oder Maschinenbauteil nach einem der Ansprüche 2 bis 5, **dadurch gekennzeichnet, dass** der Gehalt dispersen Kohlenstoffes im Gleitschichtsystems (4), und betrachtet in Richtung vom Grundkörperinnern gegen aussen fortschreitend, variiert, sei dies in Stufen oder stetig, wobei vorzugsweise in der erwähnten Richtung zunehmend, vorzugsweise stetig zunehmend und weiter bevorzugt schliesslich entlang eines Dickenabschnittes im wesentlichen konstant bleibend.

7. Werkzeug oder Maschinenbauteil nach Anspruch 6, **dadurch gekennzeichnet, dass** anschliessend an einen Dickenabschnitt variierenden Gehaltes dieser entlang eines weiteren Abschnittes im wesentlichen konstant ist.

8. Werkzeug oder Maschinenbauteil nach einem der Ansprüche 1 bis 7, **dadurch gekennzeichnet, dass** das Hartstoffschichtsystem über eine Mischschicht mit, vom Grundkörper gegen aussen betrachtet, sprunghaft oder stetig zunehmendem Gehalt des mindestens einen Metalles in die eine Zwischenschicht (3) übergeht.

9. Werkzeug oder Maschinenbauteil nach einem der Ansprüche 5 bis 8, **dadurch gekennzeichnet, dass** die weitere Zwischenschicht (2b) über eine Mischschicht, mit vom Grundkörper gegen aussen betrachtet abnehmendem, vorzugsweise stetig abnehmendem Metallgehalt in die Hartstoffschicht (2a) übergeht.

10. Werkzeug oder Maschinenbauteil nach einem der Ansprüche 2 bis 9, **dadurch gekennzeichnet, dass**, vom Grundkörperinnern nach aussen fortschreitend, das Gleitschutzschichtsystem grundkörperseitig (4b) im wesentlich erst aus dem Karbid besteht.

11. Werkzeug oder Maschinenbauteil nach einem der Ansprüche 1 bis 10, **dadurch gekennzeichnet, dass** das Hartstoffschichtsystem eine Dicke d_{HS} aufweist, für die, insbesondere wenn das Hartstoffschichtsystem aus TiAlN besteht, gilt:
0,1 µm ≤ d_{HS} ≤ 6 µm,
vorzugsweise
2 µm ≤ d_{HS} ≤ 5 µm.

12. Werkzeug oder Maschinenbauteil nach einem der Ansprüche 1 bis 11, **dadurch gekennzeichnet, dass** die eine Zwischenschicht, insbesondere wenn aus TiAl bestehend, eine Dicke d_{ZW1} aufweist, für die gilt:
0,01 µm ≤ d_{ZW1} ≤ 1 µm,
vorzugsweise
0,1 µm ≤ d_{ZW1} ≤ 0,5 µm.

13. Werkzeug oder Maschinenbauteil nach einem der Ansprüche 1 bis 12, **dadurch gekennzeichnet, dass** das Gleitschichtsystem, insbesondere wenn WC oder CrC umfassend, eine Dicke d_{GL} aufweist, für die gilt:
0,1 µm ≤ d_{GL} ≤ 6 µm,
dabei vorzugsweise
2 µm ≤ d_{GL} ≤ 3,5 µm,
wobei bevorzugterweise eine erste Schicht eines Karbides, vorzugsweise aus WC oder aus CrC, eine Dicke d_{GL1} aufweist, für die gilt:
0,01 µm ≤ d_{GL1} ≤ 1 µm,
vorzugsweise
0,1 µm ≤ d_{GL1} ≤ 0,5 µm
und mindestens eine zweite Schicht, vorzugsweise aus dem Karbid und dem dispersen Kohlenstoff, eine Dicke d_{GL2} aufweist, für die gilt:
0,1 µm ≤ d_{GL2} ≤ 5 µm,
dabei bevorzugterweise
2 µm ≤ d_{GL2} ≤ 3 µm.

14. Werkzeug oder Maschinenbauteil nach einem der Ansprüche 5 bis 13, **dadurch gekennzeichnet, dass** die weitere Zwischenschicht, insbesondere wenn aus TiAl bestehend, eine Dicke d_{ZW2} aufweist, für die gilt:
0,01 µm ≤ d_{ZW2} ≤ 1 µm,
dabei bevorzugt
0,1 µm ≤ d_{ZW2} ≤ 0,5 µm.

15. Werkzeug oder Maschinenbauteil nach einem der Ansprüche 1 bis 14, **dadurch gekennzeichnet, dass** der Metallgrundkörper aus HSS oder aus Werkzeugstahl besteht.

16. Werkzeug nach einem der Ansprüche 1 bis 15, ausgebildet als Schneidewerkzeug oder Umformwerkzeug für den Einsatz unter Mangelschmierung bis hin zum Trockeneinsatz.

17. Werkzeug oder Maschinenbauteil nach einem der Ansprüche 1 bis 16, **dadurch gekennzeichnet, dass** mindestens ein Teil des Hartstoffschichtsystems (2) durch reaktives Funkenverdampfen erzeugt ist.

18. Werkzeug oder Maschinenbauteil nach einem der Ansprüche 1 bis 17, **dadurch gekennzeichnet, dass** mindestens ein Teil des Gleitschichtsystem durch reaktives Sputtern, vorzugsweise durch reaktives Magnetronsputtern aufgebracht ist, und bevorzugt eine Laminarstruktur kohlenstoffreicherer und karbidreicherer Lagen aufweist.

19. Verfahren zur Herstellung eines Werkzeuges oder Maschinenbauteils mit erhöhter Verschleissfestigkeit und mit einem Grundkörper aus einem Metall oder aus einem Hartmetall, **gekennzeichnet durch**
- Vakuumbeschichten mindestens eines Teils der Grundkörperoberfläche mit einem Hartstoffschichtsystem, welches mindestens eine Schicht aus einem Material aus der Gruppe Nitride, Karbide, Oxide, Karbonitride, Oxinitride, Oxikarbonitride mindestens eines Metalles umfasst;
- Vakuumbeschichten des Hartstoffschichtsystems mit einer metallischen Zwischenschicht aus demselben Metall wie es die mindestens eine Schicht des Hartstoffschichtsystems umfasst;
- Vakuumbeschichten der Zwischenschicht mit einem Gleitschichtsystem.

20. Verfahren nach Anspruch 19, **dadurch gekennzeichnet, dass** das Gleitschutzschichtsystem als mindestens eine Schicht aus einem Karbid mindestens eines Metalles und dispersem Kohlenstoff gebildet wird.

21. Verfahren nach Anspruch 19, **dadurch gekennzeichnet, dass** man die mindestens eine Schicht des Hartstoffschichtsystems durch reaktives Sputtern, bevorzugt durch reaktives Magnetronsputtern oder - und dies bevorzugt - durch reaktives Funkenverdampfen, aufbringt, dabei weiter bevorzugt mindestens eines der Metalle Titan, Hafnium, Zirkonium, Aluminium eingesetzt wird, vorzugsweise mindestens zwei dieser Metalle, bevorzugt TiAl, und dabei als Reaktivgas bevorzugt ein Stickstoff-enthaltendes Gas eingesetzt wird.

22. Verfahren nach einem der Ansprüche 19 bis 21, **dadurch gekennzeichnet, dass** man mindestens eine Schicht des Gleitschichtsystems durch kathodisches Funkenverdampfen oder - und dies bevorzugt - durch reaktives Sputtern, dabei bevorzugt durch reaktives Magnetronsputter aufbringt und dabei bevorzugt ein Karbid mindestens eines Metalles der Gruppe IVb, Vb, VIb des Periodensystems der Elemente (Deming 1923) oder von Silizium aufgebracht wird, bevorzugt Wolframkarbid oder Chromkarbid, und das Karbid von einem Metalltarget oder bevorzugt von einem Karbidtarget in einer Kohlenstoff-enthaltenden Reaktivgasatmosphäre abgeschieden wird.

23. Verfahren nach einem der Ansprüche 19 bis 22, **dadurch gekennzeichnet, dass** man die metallische Zwischenschicht mit demselben Vakuumverfahren ablegt, wie die mindestens eine Hartstoffschicht des Hartstoffschichtsystems, unter Änderung des Verhältnisses gesputterten oder funkenverdampften Materials zu Reaktivgasanteil.

24. Verfahren nach einem der Ansprüche 19 bis 23, **dadurch gekennzeichnet, dass** man zwischen Grundkörperoberfläche und Harstoffschichtsystem eine weitere metallische Zwischenschicht aufbringt, dabei bevorzugterweise aus dem mindestens einen Metall, welches auch die mindestens eine Hartstoffschicht umfasst und man weiter die weitere Zwischenschicht bevorzugterweise mittels desselben Vakuumabscheideverfahrens wie die mindestens eine Hartstoffschicht abscheidet, dabei das Verhältnis von durch Sputtern oder Funkenverdampfen freigesetzten Materials zu Reaktivgasanteil variiert.

25. Verfahren nach einem der Ansprüche 19 bis 24, **dadurch gekennzeichnet, dass** man als Vakuumbeschichtungsverfahren Sputtern und reaktives Sputtern und/oder Funkenverdampfen und reaktives Funkenverdampfen einsetzt und dabei das Hartstoffschichtsystem in die eine Zwischenschicht und ggf. die weitere Zwischenschicht in das Hartstoffschichtsystem durch Variation, vorzugsweise durch stetige Variation, des Verhältnisses abgesputterten oder funkenverdampften Materials zu Reaktivgasanteil überführt und weiter bevorzugterweise beim Abscheiden des Gleitschichtsystems das Verhältnis abgesputterten Materials zu Kohlenstoffgas in der Zeit verringert und gegen Ende des Abscheidens des Gleitschutzsystems bevorzugterweise mindestens genähert konstant hält.

26. Verfahren nach einem der Ansprüche 19 bis 25, **dadurch gekennzeichnet, dass** man mindestens einen Grundkörper innerhalb einer Vakuumbehandlungskammer zyklisch an mindestens einer Sputterquelle und an mindestens einer Funkenverdampferquelle vorbeiführt und die Vakuumbeschichtungen durch Steuerung der zeitlichen Abfolge der Aktivierung von Sputterquelle und von Funkenverdampferquelle vornimmt sowie durch Steuerung der Reaktivgas-Art sowie des Reaktivgasflusses in der bzw. in die Vakuumbehandlungskammer.

27. Vakuumbehandlungsanlage, insbesondere zur Ausführung des Verfahrens nach einem der Ansprüche 15 bis 26, mit einer Vakuumbehandlungskammer (10) mit einer Mehrzahl von Öffnungen (12) und, daran montiert, mit mindestens einer Sputterquelle (15) sowie mindestens einer Niederspannungs-Entladungsquelle (14), weiter mit mindestens einem Reaktivgaseinlass sowie einer Transporteinrichtung (18) mit Werkstückaufnahme, **dadurch gekennzeichnet, dass** die Niederspannungs-Entladungsquelle eine Funkenverdampfungsquelle (14) ist, und die Transporteinrichtung zum Vorbeiführen mindestens eines Werkstückes (20) an den Öffnungen (12) ausgebildet ist.

## Claims

1. Tool or machine component, comprising:
- a base body (1) made from metal or hard metal;
- progressing from the inside of the base body towards the outside (d), first a hard material layer system (2), at least over part of the base body surface, followed by a slide layer system (4);
**characterised in that**
- the hard material layer system (2) comprises at least one hard material layer (2a) of a material from the group of nitride, carbide, oxide, carbonitride, oxinitride, oxicarbonitride of at least one metal;
- directly between the said at least one hard material layer (2a) and, proceeding in the said direction (d), before the slide layer system (4) is provided an intermediate layer (3) of the same at least one metal which is comprised in the at least one hard material layer (2a) of the hard material layer system (2).

2. Tool or machine component according to claim 1, **characterised in that** the slide layer system (4) comprises at least one slide layer (4a), which consists of a carbide of at least one metal with dispersed carbon, MeC/C.

3. Tool or machine component according to claim 1 or 2, **characterised in that** the at least one hard material layer (2a) comprises at least one of the metals titanium, hafnium, zirconium, aluminum, preferably at least two of these metals, preferably TiAl, whereby further preferably the said hard material layer consists of TiAlN.

4. Tool or machine component according to any of claims 1 to 3, **characterised in that** at least one layer (4a) of the slide layer system comprises a carbide of at least one metal of the group IVb, Vb, VIb of the periodic system of elements (Deming 1923) or silicon, preferably tungsten carbide or chromium carbide, thereby preferably a layer which lies directly on the one intermediate layer.

5. Tool or machine component according to any of claims 1 to 4, **characterised in that** between the base body surface (1) and the at least one layer (2a) of the hard material layer system (2) is provided a further intermediate layer (2b), preferably of a metal, preferably of the same at least one metal which is also comprised in the at least one layer (2a) of the hard material layer system (2).

6. Tool or machine component according to any of claims 2 to 5, **characterised in that** content of dispersed carbon in the slide layer system (4) varies, viewed progressing in the direction from the base body inside towards the outside, either in steps or continuously, preferably increasing in the said direction, preferably constantly increasing and further preferably finally remaining essentially constant along a thickness section.

7. Tool or machine component according to claim 6, **characterised in that** following a thickness section of varying content, this is essentially constant along a further section.

8. Tool or machine component according to any of claims 1 to 7, **characterised in that** the hard material layer system transits into the one intermediate layer (3) via a mixed layer in which, viewed from the base body towards the outside, the content of the at least one metal increases in steps or continuously.

9. Tool or machine component according to any of claims 5 to 8, **characterised in that** the further intermediate layer (2b) transits into the hard material layer (2a) via a mixed layer in which, viewed from the base body towards the outside, the metal content decreases preferably continuously.

10. Tool or machine component according to any of claims 2 to 9, **characterised in that**, progressing from the base body inside towards the outside, the slide protection layer system consists on the basic body side (4b) essentially first of the carbide.

11. Tool or machine component according to any of claims 1 to 10, **characterised in that** the hard material layer system has a thickness d_{Hs} for which the following is valid, in particular if the hard substance layer system consists of TiAlN:
0.1 µm ≤ d_{HS} ≤ 6 µm
preferably
2 µm ≤ d_{HS} ≤ 5 µm.

12. Tool or machine component according to any of claims 1 to 11, **characterised in that** the one intermediate layer particularly if consisting of TiAl has a thickness d_{ZW1} for which the following is valid:
0.01 µm ≤ d_{ZW1} ≤ 1 µm
preferably
0.1 µm ≤ d_{ZW1} ≤ 0.5 µm.

13. Tool or machine component according to any of claims 1 to 12, **characterised in that** the slide layer system, in particular if comprising WC or CrC, has a thickness d_{GL} for which the following is valid:
0.1 µm ≤ d_{GL} ≤ 6 µm
preferably
2 µm ≤ d_{GL} ≤ 3.5 µm,
where preferably a first layer of a carbide, preferably of WC or CrC, has a thickness d_{GL1} for which the following is valid:
0.01 µm ≤ d_{GL1} ≤ 1 µm
preferably
0.1 µm ≤ d_{GL1} ≤ 0.5 µm,
and at least one second layer, preferably of the carbide and the dispersed carbon, has a thickness d_{GL2} for which the following is valid:
0.1 µm ≤ d_{GL2} ≤ 5 µm
preferably
2 µm ≤ d_{GL2} ≤ 3 µm.

14. Tool or machine component according to any of claims 5 to 13, **characterised in that** the further intermediate layer, in particular if consisting of TiAl, has a thickness d_{ZW2} for which the following is valid:
0.01 µm ≤ d_{ZW2} ≤ 1 µm
preferably
0,1 µm ≤ d_{ZW2} ≤ 0.5 µm.

15. Tool or machine component according to any of claims 1 to 14, **characterised in that** the metal base body consists of HSS high speed steel or a tool steel

16. Tool according to any of claims 1 to 15, formed as a cutting tool or a forming tool for use under deficient lubrication through to dry use.

17. Tool or machine component according to any of claims 1 to 16, **characterised in that** at least a portion of the hard material layer system (2) is produced by reactive arc evaporation.

18. Tool or machine component according to any of claims 1 to 17, **characterised in that** least a portion of the slide layer system is applied by reactive sputtering, preferably reactive magnetron sputtering, and preferably has a laminar structure of layers richer in carbon and layers richer in carbide.

19. Method for manufacturing a tool or machine component with increased wear resistance and with a base body of a metal or a hard metal, **characterised by**:
- vacuum coating of at least a portion of the base body surface with a hard material layer system which comprises at least one layer of a material selected from the group nitride, carbide, oxide, carbonitride, oxinitride, oxicarbonitride of at least one metal;
- vacuum coating of the hard material layer system with a metallic intermediate layer of the same metal as comprised in the least one layer of the hard material layer system;
- vacuum coating of the intermediate layer with a slide layer system.

20. Method according to claim 19, **characterised in that** the slide protection layer system is formed as at least one layer of a carbide of at least one metal and dispersed carbon.

21. Method according to claim 19, **characterised in that** the at least one layer of the hard material layer system is produced by reactive sputtering, preferably by reactive magnetron sputtering or - and preferably - by reactive arc evaporation, further preferably using at least one of the metals titanium, hafnium, zirconium, aluminum, preferably at least two of these metals, preferably TiAl, and as a reactive gas preferably a nitrogen-containing gas is used.

22. Method according to any of claims 19 to 21, **characterised in that** at least one layer of the slide layer system is produced by cathodic arc evaporation or - and preferably - by reactive sputtering, preferably by reactive magnetron sputtering, and preferably using a carbide of at least one metal of the group IVb, Vb, VIb of the periodic system of elements (Deming 1923) or silicon, preferably tungsten carbide or chromium carbide, and the carbide is deposited from a metal target or preferably from a carbide target in a carbon-containing reactive gas atmosphere.

23. Method according to any of claims 19 to 22, **characterised in that** the metallic intermediate layer is deposited with the same vacuum process as the at least one hard material layer of the hard material layer system, thereby changing the ratio between amount of sputtered or arc-evaporated material and amount of reactive gas.

24. Method according to any of claims 19 to 23, **characterised in that** between the base body surface and the hard material layer system is applied a further metallic intermediate layer, preferably of the at least one metal which is also comprised in the at least one hard substance layer, and furthermore the further intermediate layer is preferably deposited by means of the same vacuum deposition method as the at least one hard material layer, whereby the ratio of amount of materials released by sputtering or arc-evaporation to amount of reactive gas is varied.

25. Method according to any of claims 19 to 24, **characterised in that** as a vacuum coating process sputtering and reactive sputtering and/or arc evaporation and reactive arc evaporation are used, and thereby the hard material layer system is transitted into the one intermediate layer and, where appropriate the further intermediate layer in the hard material layer system by variation, preferably constant variation, of the ratio between amount of sputtered or arc-evaporated material and amount of reactive gas, and further preferably when depositing the slide layer system, the ratio between amount of sputtered material to amount of carbon gas is diminished over time and towards the end of the deposition of the slide layer system preferably is kept at least approximately constant.

26. Method according to any of claims 19 to 25, **characterised in that** at least one base body within a vacuum treatment chamber is passed cyclically by at least one sputtering source and by at least one arc evaporation source, and the vacuum coatings are produced by controlling the time sequence of the activation of the sputtering source and of the arc evaporation source and by controlling the type of reactive gas and the reactive gas flow inside and into the vacuum treatment chamber.

27. Vacuum treatment installation, in particular for performance of the method according to any of claims 15 to 26, with a vacuum treatment chamber (10) with a plurality of openings (12) and with, mounted thereon, at least one sputtering source (15) and at least one low voltage discharge source (14), further with at least one reactive gas inlet and a transport device (18) with workpiece holder, **characterised in that** the low voltage discharge source is an arc evaporation source (14), and the transport device is designed for passing at least one workpiece (20) by the openings (12).

## Revendications

1. Outil ou élément de machine comprenant :
- un corps de base (1) en métal ou en métal dur ;
- de l'intérieur du corps de base vers l'extérieur, dans le sens (d), tout d'abord un système stratifié en matière dure (2), au moins sur une partie de la surface du corps de base, puis un système stratifié de glissement (4) ;
**caractérisé en ce que**
- le système stratifié en matière dure (2) comprend au moins une couche de matière dure (2a) composée d'une matière du groupe constitué par les nitrures, les carbures, les oxydes, les carbonitrures, les oxynitrures, les oxycarbonitrures d'au moins un métal ;
- il est prévu directement entre la ou les couches de matière dure (2a) mentionnées, dans le sens (d), et le système stratifié de glissement (4), une couche intermédiaire (3) composée du même ou des mêmes métaux qui constituent la ou les couches de matière dure (2a) du système stratifié en matière dure (2).

2. Outil ou élément de machine selon la revendication 1, **caractérisé en ce que** le système stratifié de glissement (4) comprend au moins une couche de glissement (4a) constituée par un carbure d'au moins un métal avec du carbone dispersé, MeC/C.

3. Outil ou élément de machine selon la revendication 1 ou 2, **caractérisé en ce que** la ou les couches de matière dure (2a) contiennent l'un au moins des métaux constitués par le titane, le hafnium, le zirconium, l'aluminium, de préférence au moins deux de ces métaux, de préférence TiAl, la couche de matière dure mentionnée se composant de préférence de TiAlN.

4. Outil ou élément de machine selon l'une des revendications 1 à 3, **caractérisé en ce qu'**au moins une couche (4a) du système stratifié de glissement comporte un carbure d'au moins un métal du groupe IVb, Vb, VIb de la classification périodique des éléments (Deming 1923) ou de silicium, de préférence du carbure de tungstène ou du carbure de chrome, de préférence une couche qui est appliquée directement sur une couche intermédiaire.

5. Outil ou élément de machine selon l'une des revendications 1 à 4, **caractérisé en ce qu'**il est prévu entre la surface de corps de base (1) et la ou les couches (2a) du système stratifié en matière dure (2) une autre couche intermédiaire (2b), de préférence en métal, de préférence du même métal ou des mêmes métaux qui constituent aussi la ou les couches (2a) du système stratifié en matière dure (2).

6. Outil ou élément de machine selon l'une des revendications 2 à 5, **caractérisé en ce que** la teneur en carbone dispersé dans le système stratifié de glissement (4) varie de l'intérieur du corps de base vers l'extérieur, par paliers ou de manière continue, de préférence en augmentant dans le sens indiqué, de préférence de manière continue et plus spécialement, enfin, en restant pratiquement constante le long d'une section d'épaisseur.

7. Outil ou élément de machine selon la revendication 6, **caractérisé en ce que** dans le prolongement d'une section d'épaisseur de teneur variable, celle-ci est pratiquement constante le long d'une autre section.

8. Outil ou élément de machine selon l'une des revendications 1 à 7, **caractérisé en ce que** le système stratifié en matière dure se prolonge par une couche intermédiaire (3) par l'intermédiaire d'une couche mixte à teneur en métal ou en métaux qui augmente, de manière discontinue ou continue, du corps de base vers l'extérieur.

9. Outil ou élément de machine selon l'une des revendications 5 à 8, **caractérisé en ce que** l'autre couche intermédiaire (2b) se prolonge par la couche de matière dure (2a) par l'intermédiaire d'une couche mixte à teneur en métal qui diminue, de préférence de manière continue, du corps de base vers l'extérieur.

10. Outil ou élément de machine selon l'une des revendications 2 à 9, **caractérisé en ce que** de l'intérieur du corps de base vers l'extérieur, le système stratifié antidérapant se compose tout d'abord essentiellement du carbure, côté corps de base (4b).

11. Outil ou élément de machine selon l'une des revendications 1 à 10, **caractérisé en ce que** le système stratifié en matière dure présente une épaisseur d_{HS} pour laquelle, en particulier lorsque le système stratifié en matière dure se compose de TiAlN, on a :
0,1 µm ≤ d_{HS} ≤ 6 µm,
de préférence
2 µm ≤ d_{HS} ≤ 5 µm.

12. Outil ou élément de machine selon l'une des revendications 1 à 11, **caractérisé en ce que** l'une des couches intermédiaires, composée en particulier de TiAl, présente une épaisseur d_{ZW1} :
0,01 µm ≤ d_{ZW1} ≤ 1 µm,
de préférence
0,1 µm ≤ d_{ZW1} ≤ 0,5 µm.

13. Outil ou élément de machine selon l'une des revendications 1 à 12, **caractérisé en ce que** le système stratifié de glissement, en particulier s'il contient WC ou CrC, présente une épaisseur d_{GL} :
0,1 µm ≤ d_{GL} ≤ 6 µm,
de préférence
2 µm ≤ d_{GL} ≤ 3,5 µm, étant précisé qu'une première couche d'un carbure, de préférence de WC ou CrC, présente de préférence une épaisseur d_{GL1} :
0,01 µm ≤ d_{GL1} ≤ 1 µm,
de préférence
0,1 µm ≤ d_{GL1} ≤ 0,5 µm
et qu'au moins une seconde couche, de préférence composée du carbure et du carbone dispersé, présente une épaisseur d_{GL2} :
0,1 µm ≤ d_{GL2} ≤ 5 µm,
de préférence
2 µm ≤ d_{GL2} ≤ 3 µm.

14. Outil ou élément de machine selon l'une des revendications 5 à 13, **caractérisé en ce que** l'autre couche intermédiaire, en particulier si elle est composée de TiAl, présente une épaisseur d_{ZW2} :
0,01 µm ≤ d_{ZW2} ≤ 1 µm,
de préférence
0,1 µm ≤ d_{ZW2} ≤ 0,5 µm.

15. Outil ou élément de machine selon l'une des revendications 1 à 14, **caractérisé en ce que** le corps de base en métal se compose de HSS ou d'acier à outils.

16. Outil selon l'une des revendications 1 à 15, conçu comme un outil de coupe ou un outil de façonnage à utiliser dans les cas qui vont d'une lubrification insuffisante à une utilisation sèche.

17. Outil ou élément de machine selon l'une des revendications 1 à 16, **caractérisé en ce qu'**une partie au moins du système stratifié en matière dure (2) est produite par évaporation réactive par étincelles.

18. Outil ou élément de machine selon l'une des revendications 1 à 17, **caractérisé en ce qu'**une partie au moins du système stratifié de glissement est appliquée par pulvérisation réactive, de préférence par magnétron, et présente de préférence une structure laminaire de couches riches en carbone et riches en carbure.

19. Procédé pour fabriquer un outil ou un élément de machine présentant une résistance à l'usure accrue et comportant un corps de base composé d'un métal ou d'un métal dur, **caractérisé**
- **en ce qu'**on revêt sous vide une partie au moins de la surface du corps de base avec un système stratifié en matière dure qui comprend au moins une couche composée d'un matériau du groupe constitué par les nitrures, les carbures, les oxydes, les carbonitrures, les oxynitrures, les oxycarbonitrures d'au moins un métal ;
- **en ce qu'**on revêt sous vide le système stratifié en matière dure avec une couche métallique intermédiaire composée du même métal que celui qui est contenu dans la ou les couches dudit système stratifié en matière dure ;
- **en ce qu'**on revêt sous vide la couche intermédiaire avec un système stratifié de glissement.

20. Procédé selon la revendication 19, **caractérisé en ce que** le système stratifié antidérapant est conçu comme au moins une couche composée d'un carbure d'au moins un métal et de carbone dispersé.

21. Procédé selon la revendication 19, **caractérisé en ce qu'**on applique la ou les couches du système stratifié en matière dure par pulvérisation réactive, de préférence par magnétron, ou bien, de préférence, par évaporation réactive par étincelles, étant précisé qu'on utilise de préférence l'un au moins des métaux constitués par le titane, le hafnium, le zirconium, l'aluminium, de préférence au moins deux de ces métaux, de préférence TiAl, et qu'on utilise de préférence comme gaz réactif un gaz contenant de l'azote.

22. Procédé selon l'une des revendications 19 à 21, **caractérisé en ce qu'**on applique au moins une couche du système stratifié de glissement par évaporation cathodique par étincelles ou bien, de préférence, par pulvérisation réactive et de préférence par magnétron, étant précisé qu'on applique de préférence un carbure d'au moins un métal du groupe IVb, Vb, VIb de la classification périodique des éléments (Deming 1923) ou de silicium, de préférence du carbure de tungstène ou du carbure de chrome, et que le carbure est séparé d'une cible métallique ou de préférence d'une cible de carbure dans une atmosphère de gaz réactif contenant du carbone.

23. Procédé selon l'une des revendications 19 à 22, **caractérisé en ce qu'**on dépose la couche intermédiaire métallique avec le même procédé sous vide que la ou les couches de matière dure du système stratifié en matière dure, avec une modification du rapport de la matière pulvérisée ou évaporée par étincelles sur la proportion de gaz réactif.

24. Procédé selon l'une des revendications 19 à 23, **caractérisé en ce qu'**on applique entre la surface du corps de base et le système stratifié en matière dure une autre couche intermédiaire métallique composée de préférence du ou des métaux contenus aussi dans la ou les couches de matière dure, et on sépare cette autre couche intermédiaire de préférence avec le même procédé de séparation sous vide que la ou les couches de matières dures, étant précisé que le rapport de la matière dégagée par la pulvérisation ou l'évaporation par étincelles sur la proportion de gaz réactif varie.

25. Procédé selon l'une des revendications 19 à 24, **caractérisé en ce qu'**on utilise comme procédé d'application de revêtement sous vide la pulvérisation cathodique et la pulvérisation réactive et/ou l'évaporation par étincelles et l'évaporation réactive par étincelles, étant précisé que le système stratifié en matière dure se prolonge par la première couche intermédiaire et éventuellement la seconde couche intermédiaire se prolonge par le système stratifié en matière dure grâce à une variation, de préférence continue, du rapport de la matière déposée par pulvérisation ou évaporée par étincelles sur la proportion de gaz réactif, et que lors de la séparation du système stratifié de glissement, le rapport de la matière déposée par pulvérisation cathodique sur le gaz carbonique diminue dans le temps et reste de préférence au moins approximativement constant vers la fin de la séparation du système antidérapant.

26. Procédé selon l'une des revendications 19 à 25, **caractérisé en ce qu'**on fait passer de manière cyclique au moins un corps de base, à l'intérieur d'une chambre de traitement sous vide, devant au moins une source de pulvérisation cathodique et devant au moins une source d'évaporation par étincelles, et on procède aux applications de revêtement sous vide en commandant la succession dans le temps de l'activation desdites sources de pulvérisation d'évaporation par étincelles, et en commandant le type de gaz réactif ainsi que le flux de gaz réactif qui se trouve et qui arrive dans la chambre de traitement sous vide.

27. Installation de traitement sous vide, en particulier pour mettre en oeuvre le procédé selon l'une des revendications 15 à 26, comprenant une chambre de traitement sous vide (10) pourvue de plusieurs ouvertures (12), au moins une source de pulvérisation cathodique (15) et au moins une source de décharge basse tension (14) montée sur ces ouvertures, au moins une admission de gaz réactif et un dispositif de transport (18) à porte-pièce, **caractérisée en ce que** la source de décharge basse tension est une source d'évaporation par étincelles (14) et le dispositif de transport est conçu pour faire passer au moins une pièce (20) devant les ouvertures (12).
